# EUROPEAN PATENT SPECIFICATION

(11) **EP 2 891 176 B1**
(45) Date of publication and mention of the grant of the patent: **15.06.2016**
(21) Application number: 12888184.4
(22) Date of filing: 09.11.2012
(51) Int. Cl.: H01L 35/32, H01L 35/30

(54) **THERMOELECTRIC ASSEMBLY**
THERMOELEKTRISCHE ANORDNUNG
ASSEMBLAGE THERMOÉLECTRIQUE

(43) Date of publication of application: 08.07.2015
(73) Proprietor: Laird Technologies, Inc., Earth City, MO 63045 (US)
(72) Inventor: HÖJER, Henrik, 442 39 Kungälv (SE); THOREN, Andérs, 41253 Göteborg (SE); KARLSTEDT, Dan Martin Gustav, South Earth City, Missouri (US)
(74) Representative: Awapatent AB
(86) International application number: PCT/US2012/064375
(87) International publication number: WO 2014/074110

(56) References cited:
- JP-A- H11 294 891
- JP-A- 2012 004 454
- KR-A- 20040 045 667
- KR-B1- 100 789 945
- KR-B1- 101 125 151
- US-A- 4 782 664
- US-A1- 2005 000 231
- US-B1- 6 530 231

## Description

### FIELD

The present disclosure relates to thermoelectric assemblies.

### BACKGROUND

This section provides background information related to the present disclosure which is not necessarily prior art.

The Peltier effect is an effect in which a heat flux is created between the junction of two different types of materials. Thermoelectric modules (TEMs) are semiconductor devices which use the Peltier effect to transfer heat from one side of the TEM (the "cold side") to the other side of the TEM (the "hot side"). The TEM, a solid-state Peltier device, effectively acts as a heat pump upon the application of a DC power source to the TEM. Heat is moved through the TEM, from one side to the other, with consumption of electrical energy, depending on the direction of the current. Such an instrument may also be called a Peltier cooler or heater, a thermoelectric heat pump, a Peltier heat pump, a solid state refrigerator, a thermoelectric cooler (TEC), or a thermoelectric module (TEM). TEMs can be used either for heating or for cooling (refrigeration), although in practice the main application is cooling.

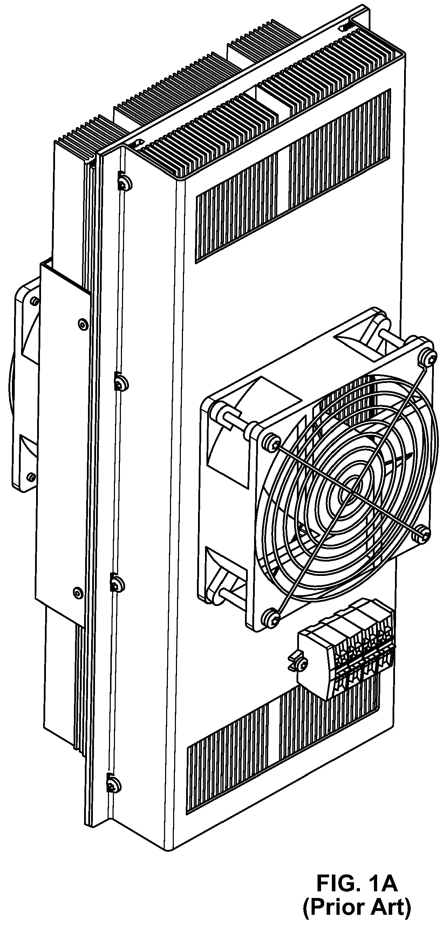

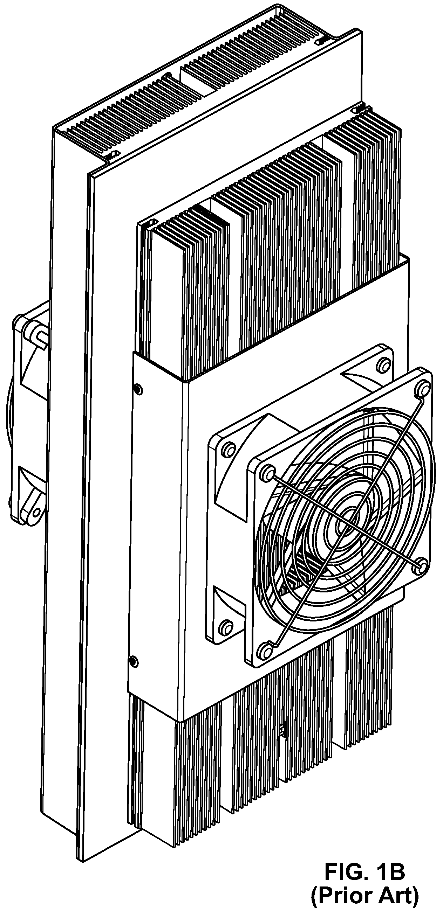

Thermoelectric assemblies (TEAs) often include a pair of fan sinks that face outwardly in opposite directions and meet at one or more TEMs at their bases. As can be seen in Figures 1A & 1B, which represent an example of the prior art, a TEA may comprise a cold side fan sink, a hot side fan sink, and a plurality of TEMs disposed between the fan sinks. A cold side fan sink typically includes a fan mounted on a heat sink, often through the use of a fan housing over the heat sink fins. The TEA may also include a gasket, often made of a foam, that surrounds the TEMs that are in contact with the base of the cold side heat sink. The TEMs are typically arranged in one or more parallel circuits. A hot side fan sink is analogous to the cold side fan sink, and the two fan sinks are both in thermal contact with the TEMs and the gasket at the heat sink bases.
Document US 4,782,664 discloses a thermoelectric heat exchanger with a first fanned heat sink and two second heat sinks. Cooling elements are arranged in planar regions between the first heat sink and the second heat sinks.

### SUMMARY

This section provides a general summary of the disclosure, and is not a comprehensive disclosure of its full scope or all of its features.

In one aspect, a thermoelectric assembly has a cold side and a hot side. The boundary between the hot side and the cold side may be generally defined by a plane. One or more thermoelectric modules may be in the plane and arranged in one circuit or multiple parallel circuits, and in direct thermal contact with both the hot side and the cold side.

The hot side comprises a single fan sink, whereas the cold side comprises a pair of fan sinks. A fan sink is a heat sink and a fan, each fan comprising a blade, and each heat sink comprising a fin set, where a fin set is a series of parallel protrusions on a heat sink base, the parallel protrusions aligned in a single exhaust direction.

In an embodiment, each fan sink possesses an air intake direction defined by an axis about which the blade is rotatably attached to the fan, and the air intake direction is at an angle of ninety degrees from the air exhaust direction. The air intake directions of the pair of fan sinks on the cold side are parallel. Further, the angle defined by the air exhaust directions of the pair of fan sinks on the cold side may be selected from the group consisting of zero degrees, ninety degrees, and one hundred eighty degrees.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure.
Figure 1A shows a perspective view of one side of a thermoelectric assembly of the prior art.
Figure 1B shows a perspective view of the other side of the thermoelectric assembly of the prior art seen in Figure 1A.
Figure 2A shows a cross sectional example of a single piece heat sink.
Figure 2B shows a cross sectional example of a multi-piece heat sink.
Figure 3 shows a perspective view of an embodiment of a thermoelectric assembly, this view showing a pair of cold side fan sinks.
Figure 4A shows an embodiment of the air flow configuration of the cold side fan sinks, this embodiment showing the 180° air flow differential.
Figure 4B shows an embodiment of the air flow configuration of the cold side fan sinks, this embodiment showing the 90° air flow differential.
Figure 4C shows an embodiment of the air flow configuration of the cold side fan sinks, this embodiment showing the 0° air flow differential.
Figure 5 shows an exploded perspective view of an embodiment of a thermoelectric assembly with a sealing layer, as well as an embodiment of the moisture protection screw lead.
Figure 6A shows a perspective view of an embodiment of the moisture protection screw lead.
Figure 6B shows a cross sectional view of an embodiment of the moisture protection screw lead seen in Figure 6A.
Figure 7A shows a cross sectional view of an embodiment of a moisture protected screw joint O-ring.
Figure 7B shows an exploded view of the embodiment of the moisture protected screw joint O-ring seen in Figure 7A.
Figure 8A shows a diagram of an embodiment of a TEA having a single circuit of two TEMs.
Figure 8B show a diagram of an embodiment of a TEA having two parallel circuits of two TEMs each.
Figure 8C shows a diagram of an embodiment of a TEA having two parallel circuits of four TEMs each.
Figure 9 shows a perspective view of an embodiment of a TEM suitable for use in the present assembly.
Figure 10 shows a side view of the embodiment of the TEM seen in Figure 9.

### DETAILED DESCRIPTION

Exemplary embodiments will now be described more fully with reference to the accompanying drawings.

TEAs operate generally as follows: On the cold side, the fan pulls the surrounding air into the heat sink channels that are defined by the space between the heat sink fins, thereby drawing substantial ambient air over the cold side fins to facilitate an eventual air-to-metal thermal transfer on the cold side. The TEMs are in physical thermal contact with the bases of the heat sinks. The TEMs pump thermal energy from the cold side heat sink base onto the base of the hot side heat sink. As the hot side heat sink warms due to the heat pumped into them by the TEMs, the hot side fan cools the fins of the hot side heat sink by drawing ambient air across them and expelling warm air from the hot side air channels. In essence, the TEMs pump heat from one side of the unit to the other while the fan sinks provide substantial surface area and air flow therethrough to enable an efficient heat transfer.

A frequent problem in the art arises from the condensation that accumulates on the cold side heat sink during operation of the thermoelectric assembly. As the temperature of the cold side heat sink dips below the dew point of the ambient air around the cold side during the operation of the assembly, moisture accumulates on the exposed surface of the cold side heat sink. This condensation can create performance issues, reduce effective surface area of the heat sink fins, and give rise to water-borne organic growth that can cause foul odors, among other problems.

Frequently, a TEA is to be installed on the vertical walls of a pre-existing structure, as opposed to installation as a part of a new construction. Due to the existing conditions of the structure, such as the placement of doors, windows, studs, wiring, vents, *etc.,* the TEA may need to be installed with the heat sink fins running horizontally as opposed to vertically. Where the heat sink fins are horizontal, condensation moisture control is difficult to achieve with a fan alone, whereas a vertical heat sink fin arrangement may be more efficiently drained of condensate with the assistance of gravity.

Additionally, condensation moisture may permeate the interior of the TEA through holes in the heat sink used for wiring or bolts / screws. This moisture can cause performance issues on the assembly, including potentially shorting out one or more of the parallel TEM circuits or other electrical components of the unit.

Fan sinks are known mechanisms for forced air convection, which provides a more efficient air-to-metal or metal-to-air thermal transfer. Additionally, the forced convection mechanism aids in preventing oxidation of the heat sink material through the continuous movement of ambient air.

Thermoelectric modules are essentially solid state heat pumps comprising positively and negatively doped modules. They may be arranged in a single series circuit or in several parallel circuits, or any combination thereof. In non-limiting embodiments, for example where eight TEMs are present in the TEA, the TEMs may be arranged in four parallel circuits of two series connected TEMs, two parallel circuits of four series connected TEMs, or eight separate TEMs each on a single circuit.

In one aspect, a TEA comprising a hot side and a cold side is disclosed, where the cold side comprises two or more fan sinks, while the hot side comprises a single fan sink. A TEA may be mounted on a vertical surface of an enclosure, such as a wall, to provide cooling of the ambient air on one side of the enclosure wall through the transfer of heat to the other side of the enclosure wall.

As referred to herein, the terms hot side and cold side do not necessarily indicate one side as literally "hot" or "cold." Rather, an aim of the TEA disclosed herein is to transfer heat from the cold side to the hot side, thereby providing a relative cooling to the cold side. For example, a rooftop electrical service room with a TEA device installed would transfer heat from the warm inside to the potentially cooler ambient outside. Conversely, a TEA device installed on an indoor wine cooler or wine chiller that is colder than the surrounding ambient room temperature would be cooled by transferring heat from the cooler cold side to the warmer hot side. As such, the terms hot side and cold side are not intended to be limiting in the sense that the sides are literally hot or cold, but merely intended to show an embodiment of potential thermal flow of a TEA.

Additionally, the TEA may include a series of moisture barrier measures that, when used in concert and installed on a TEA, substantially eliminate the moisture problems seen in the art. Primarily, these moisture barrier measures include a sealing layer in or near the plane that defines the hot and cold sides, an O-ring sealed screw joint, and a moisture protected wire seal. Each of these individually may be considered a suitable means for moisture protection. In an embodiment, each of the sealing layer, screw joint, and wire seal together comprise a comprehensive moisture barrier system.

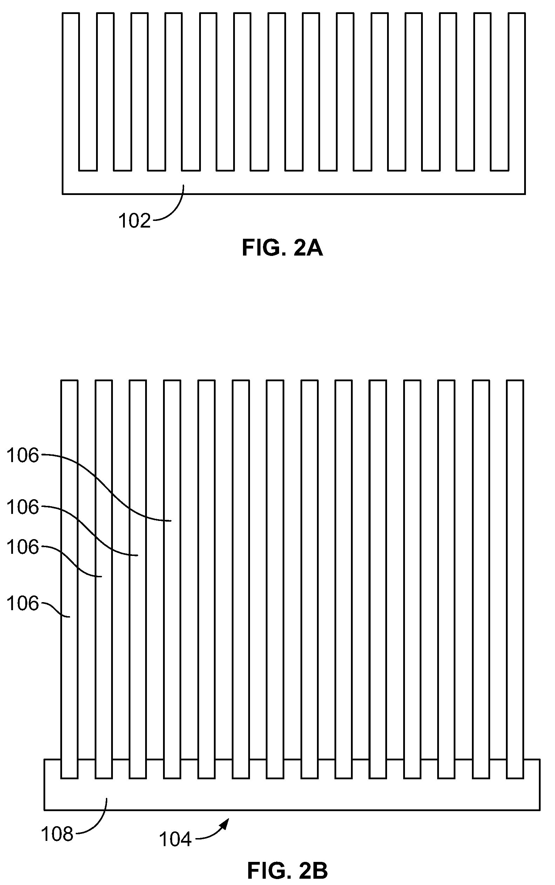

Though heat sinks are not so limited in shape, heat sinks suitable for use in TEA generally comprise a rectangular base upon which a series of fins, referred to as a fin set, protrude. Fins may be substantially parallel panels of material, often the same material as the base. Two exemplary types of heat sinks can be seen in Figures 2A and 2B. Figure 2A shows a cross section of a single piece or one-piece heat sink **102.** Conversely, Figure 2B shows a cross section of a multi piece heat sink **104,** where the multi piece heat sink comprises a series of fins **106** that have been mounted on a base 108.

As seen in Figure 2A, a heat sink may be a block of metal, such as copper or anodized aluminum, or thermoelectric material, such as thermally-conductive polymer composites, that has, for example, been skived, molded, or extruded to create a series of parallel ribs on a base. In certain instances, such as where the desired rib height is substantial enough that skiving of the entire heat sink is inappropriate, a heat sink base may be constructed of a skived, extruded, or molded base, whereupon individual fins are mounted within the skived recesses of the heat sink base, as seen in Figure 2B. In an embodiment where the heat sink is comprised of a thermally-conductive polymer composite, the heat sink may be made through injection molding or thermoset molding. A multi-piece heat sink may be needed if, for example, an application requires fins of such a depth that skiving is not practical. In either case, the fan sinks of a TEA may be suitable for either a single piece heat sink or a multi-piece heat sink.

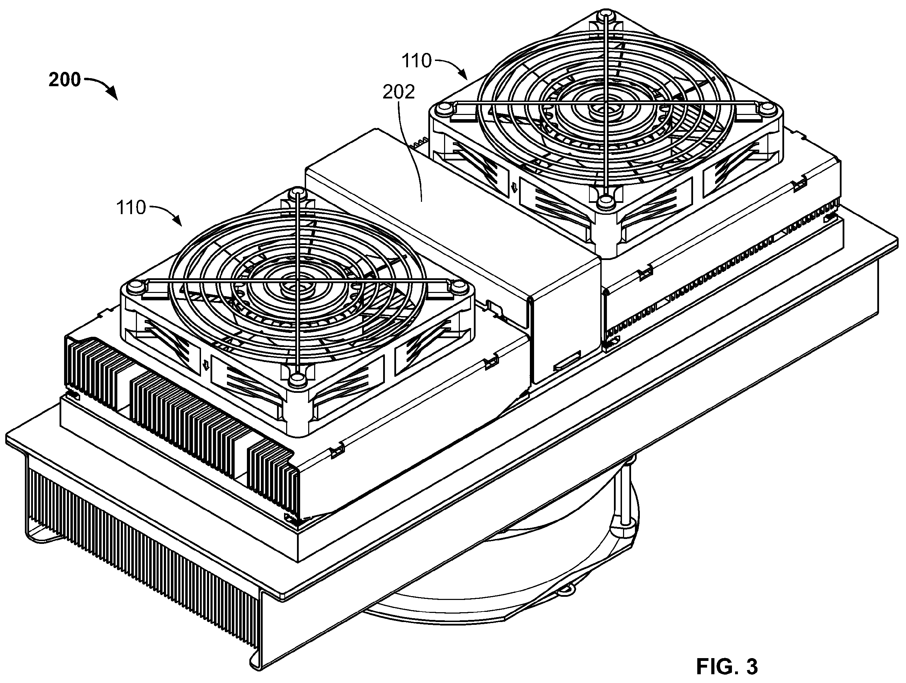

A fan sink generally comprises a heat sink and a fan. An exemplary fan sink can be seen as a component of the thermoelectric assembly of Figure 3. Each fan comprises a blade that rotates about an axis. The fan is mounted on or near a heat sink and pulls air through each fan and onto and through the heat sink fin set. The air flows into the heat sink channels that are defined by the space between the heat sink fins. Each fan sink possesses an air intake direction defined by the axis about which the blade is rotatably attached to the fan. Similarly, each fan sink comprises an exhaust direction that is perpendicular to the intake direction and generally parallel to the linear arrangement of the fin set. A heat sink may have a greater width than its corresponding fan.

Referring further to the Figures, Figure 3 shows an embodiment of a thermoelectric assembly **200** having dual cold side fan sinks **110.** Comparing Figures 1A and 1B to Figure 3, the space between the dual cold side fan sinks **110** in Figure 3 has permitted the placement of an electric bay **202** between the two fan sinks. Conversely, the electrical connections of the prior art TEA of Figure 1A is exposed and susceptible to moisture issues. As seen in Figure 3, the electric bay **202** may be a centralized housing containing electrical components and connections.

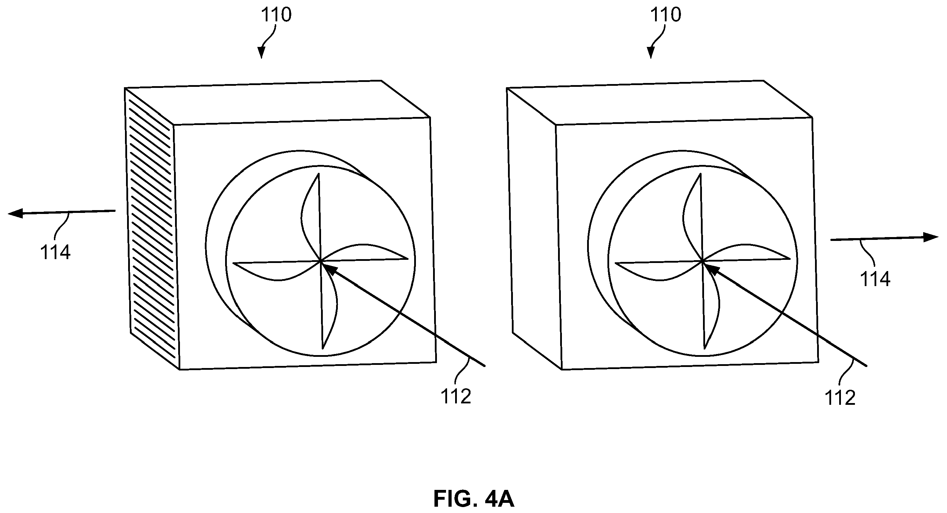

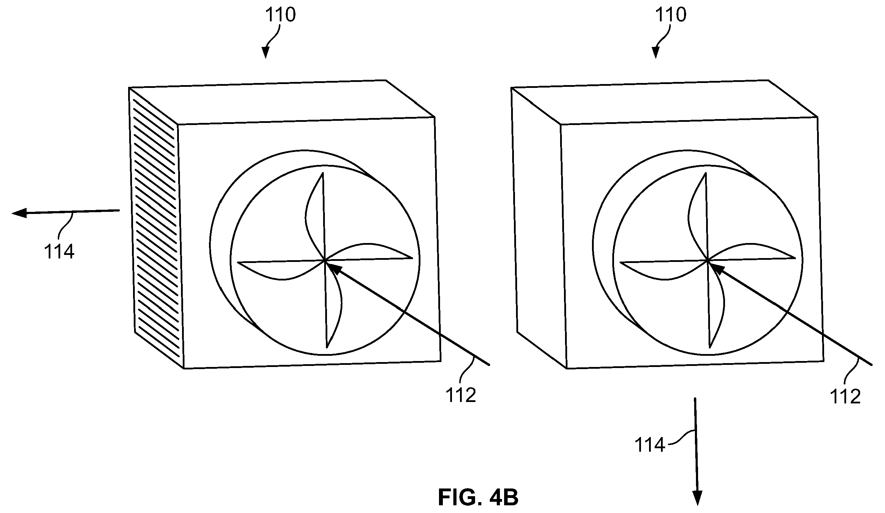

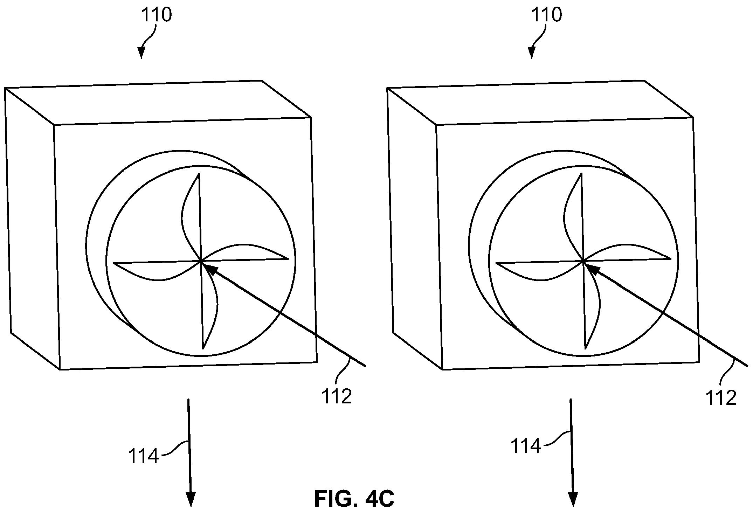

Referring now to Figures 4A, 4B, and 4C, two fan sinks **110** may be aligned next to one another such that the two fan sinks have air intake directions **112** that are parallel and in the same direction. The fan sinks **110** may be arranged, however, such that their exhaust directions **114** are parallel or perpendicular to one another, and so that each fan sink has a single exhaust direction and one fan sink does not blow exhaust air on the other. In this manner, bi-directional configurable air flow is possible on the cold side of a TEA. Specifically, Figure 4A depicts two fan sinks **110** that have exhaust directions **114** represented by opposite vectors, at 180 degrees from one another, while the intake directions **112** are represented by parallel vectors. Figure 4B depicts two fan sinks **110** with exhaust directions **114** represented by vectors that are perpendicular to one another, at 90 degrees from one another. Figure 4C depicts two fan sinks **110** with exhaust directions **114** that are represented by parallel vectors but are zero degrees from one another. This flexibility and modular configurations of the fan sinks **110** seen in Figures 4A, 4B, and 4C is not seen in the thermoelectric assemblies of the prior art. Note that the embodiment of the thermoelectric assembly **200** of Figure 3 shows the 90 degree configuration of Figure 4B.

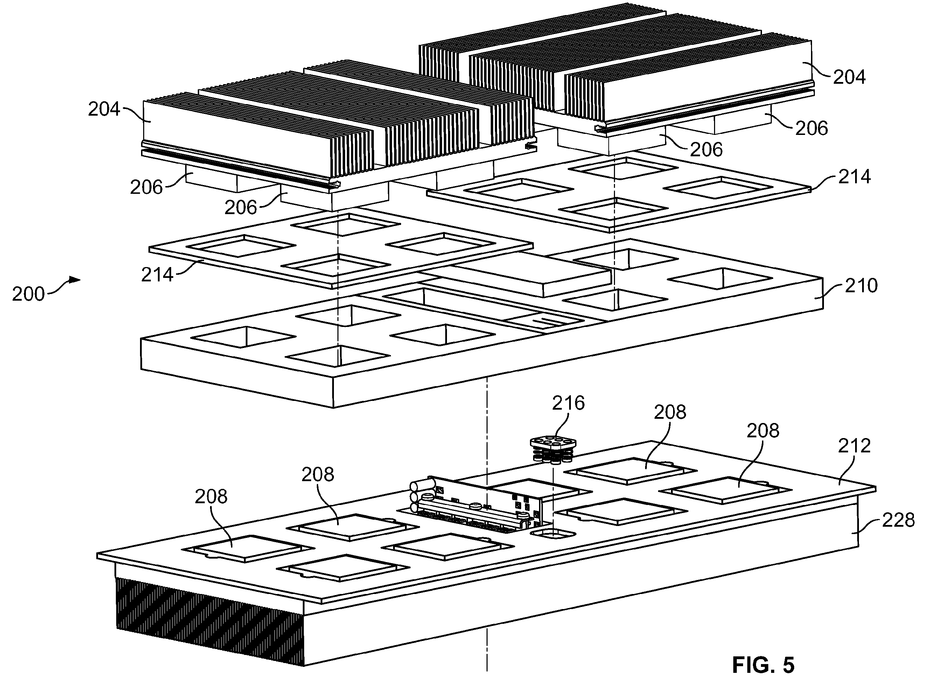

Figure 5 shows an exploded perspective view of an exemplary thermoelectric assembly **200,** including moisture barrier measures. Figure 5, in the interest of clarity, shows dual cold side heat sinks **204** without their respective fans, as well as a single large hot side heat sink **228** without a fan. Figure 5 more clearly illustrates the plane that generally defines the hot and cold sides of the TEA, within which the TEMs reside.

Further, the cold side heat sinks **204** of Figure 5 comprise generally square protrusions **206** that descend from the base of the heat sink. The TEMs **208** are in thermal contact with the bases of the heat sinks. As seen in the exploded view of Figure 5, the TEMs **208** would be in direct thermal contact with the protrusions **206** of the cold side heat sinks **204.** However, the TEMs **208** would be in direct thermal contact with a flush planar base of a large cold side heat sink **228.**

Figure 5 additionally shows an insulation gasket **210.** Insulation gaskets, as can be seen in Figure 5, may be die cut or otherwise cut to permit the heat sink protrusions **206** to pass therethrough and make contact with the TEMs **208.** This improves TEA efficiency as an insulating material, forming a perimeter seal around the protrusions. Insulation gaskets may be made of any suitable material known in the art, including semi-closed or closed cell foam such as neoprene. Once the TEA is fully assembled, however, frequently the semi-closed foam's cell structure is compressed to form a completely closed cell structure, thereby improving efficiency and partially reducing moisture permeation. Another thinner insulation gasket **212** may be added around the TEMs **208** to serve generally the same purpose as the larger insulation gasket **210.**

Improving upon the insulation gasket **210,** however, it was found that adding additional sealing layers **214** for each cold side heat sink **204,** particularly those with protrusions **206,** to pass through to the TEMs **208** further reduced moisture penetration. Traditional insulation gaskets are not flexible enough to seal around the heat sinks at their base, particularly because the bases of heat sinks can be rough from skiving or other manufacturing processes. By adding additional semi-closed or closed foam cell insulation to the TEAs, the TEA may be further sealed against moisture permeation.

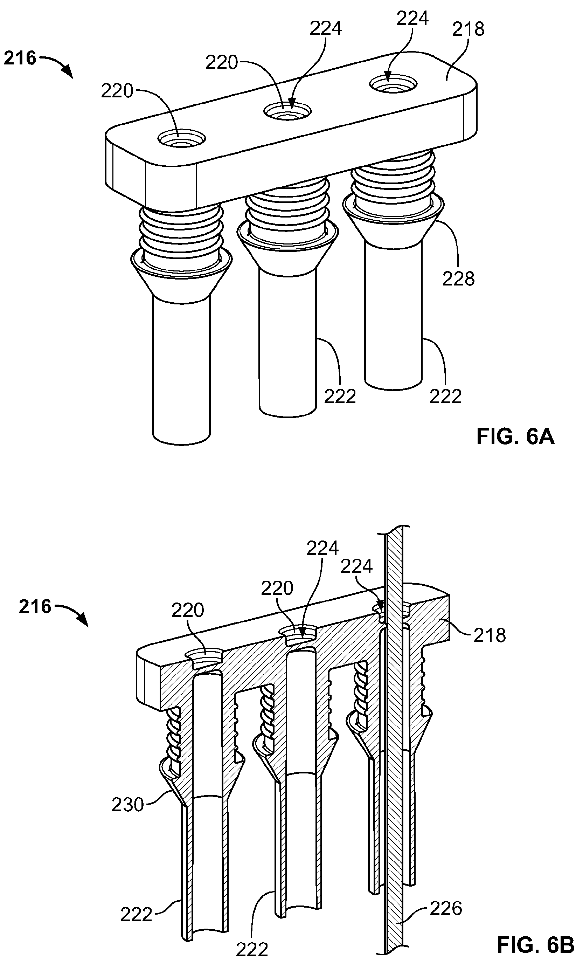

In addition to the moisture seal improvements via the sealing layers **214** seen in Figure 5, the particularly vulnerable areas of the TEAs that would otherwise be susceptible to moisture permeation due to the presence of holes in the heat sinks have been addressed. Holes are present in the heat sinks to allow for physical and electrical connections, for example, using screws and wires. As can be seen in Figures 6A and 6B, a unique wire seal **216** is disclosed. Referring to Figures 6A and 6B together, each wire seal **216** comprises a head **218,** each head comprising one or more holes **220** in the head **218,** through which a wire **226** may pass into a lead **222,** each pairing of a hole and lead comprising a membrane **224** that provides a snug seal against any wire **226.** The membrane **224** may be a closed permeable membrane that is punctured by a wire during TEA manufacture, or remains intact and impermeable to moisture if a particular hole and lead pairing is unused during TEA manufacture.

For example, the wire seal **216** of Figure 5 shows a head with six hole and lead pairings arranged in a 2 x 3 matrix, whereas the wire seal of Figures 6A and 6B show a head with three hole and lead pairings arranged in a 1 x 3 matrix. In the event a 2 x 3 matrix wire seal is used in a TEA assembly, but only four wires are used, the two unpenetrated membranes will provide a moisture barrier, while the four penetrated membranes will provide a snug seal against any wire passing therethrough. The wire seal **216** may further comprise a shelf **230** that snugly secures the wire seal to the TEA.

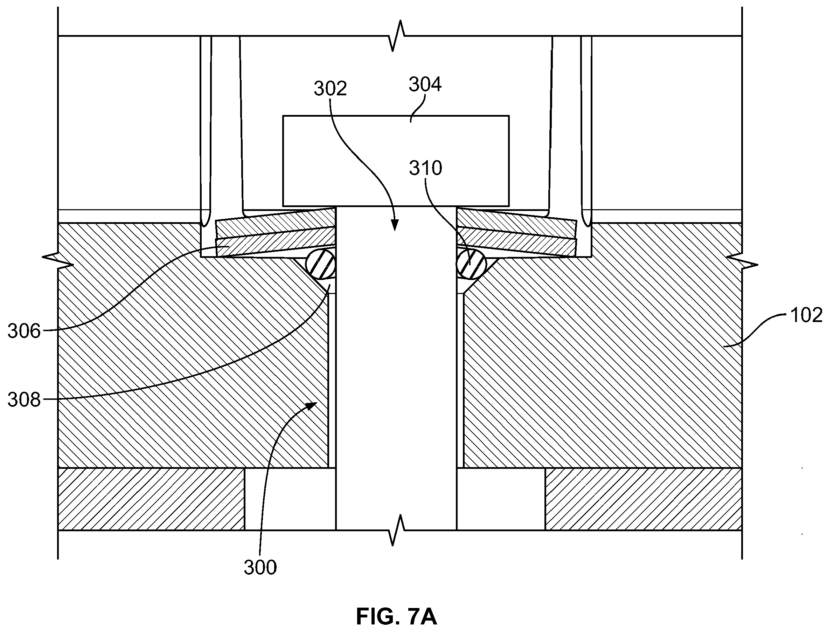

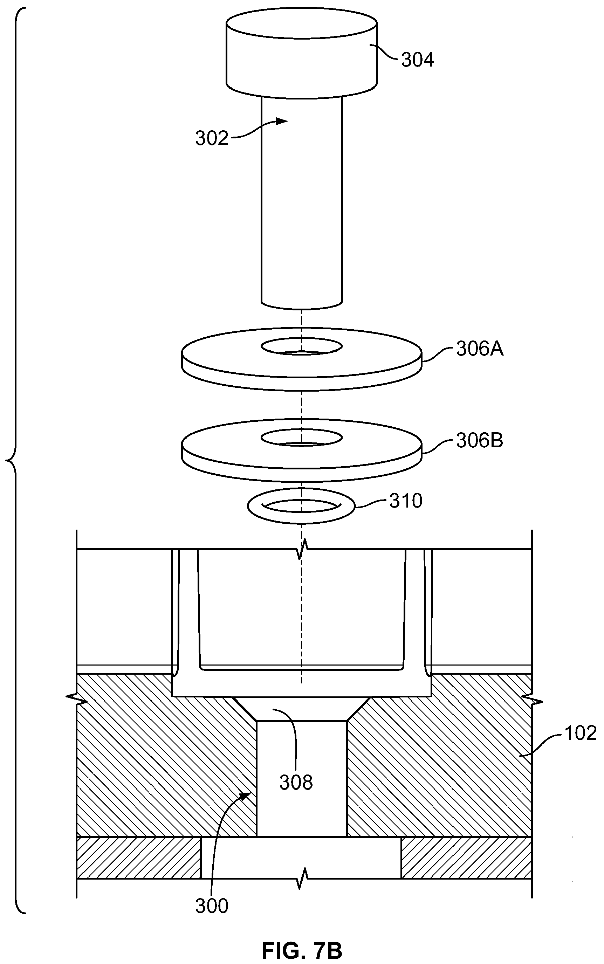

Addressing the issue of moisture passing through the screw holes, it was found that creating a frustal surface at the top of a screw hole permitted the insertion of an O-ring below the screw head. This may be seen in Figure 7, where a cross sectional view of a sealed screw joint is shown. At the bottom of a heat sink **102,** a series of screw holes **300** are present to permit the passage of a screw **302** therethrough to secure the TEA's hot side and cold side together. Below each screw head **304,** it is common in the art to include one or more disk springs **306** (*e.g.,* disk springs **306A, 306B** in Figure 7B, *etc.*) or other type of washer. However, in an effort to significantly reduce moisture permeation, the screw hole 300 has been to include a frustal surface **308** within which an O-ring **310** may reside. The presence of the O-ring **310,** in conjunction with the other moisture barrier measures discussed herein, substantially eliminates moisture permeation and the malfunctions related thereto.

The TEA may further comprise electrical wiring such that the TEMs, as previously discussed, are in one or more parallel circuits, and sufficient to power the fans. Electrical components and connections may be housed in an electrical bay **202** between the cold side fan sinks **110** as shown in Figure 3. The TEMs, once sufficient voltage is applied, will pump heat from the cold side heat sink bases to the hot side heat sink base.

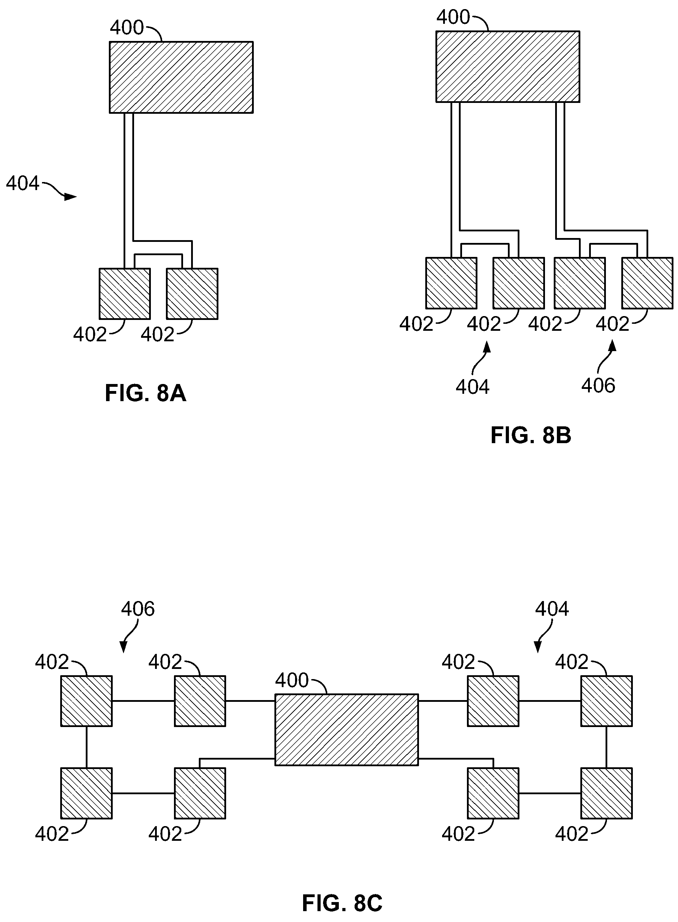

Referring to Figure 8A, the thermoelectric assembly power source **400** may be wired to a single circuit **404** of two thermoelectric modules **402.** Figure 8B shows an embodiment where the power source **400** is wired to two parallel circuits **404, 406,** each comprising two thermoelectric modules **402.** Figure 8C shows yet another embodiment of a power source **400** wired to two parallel circuits **404, 406,** each comprising a series of four thermoelectric modules **402.**

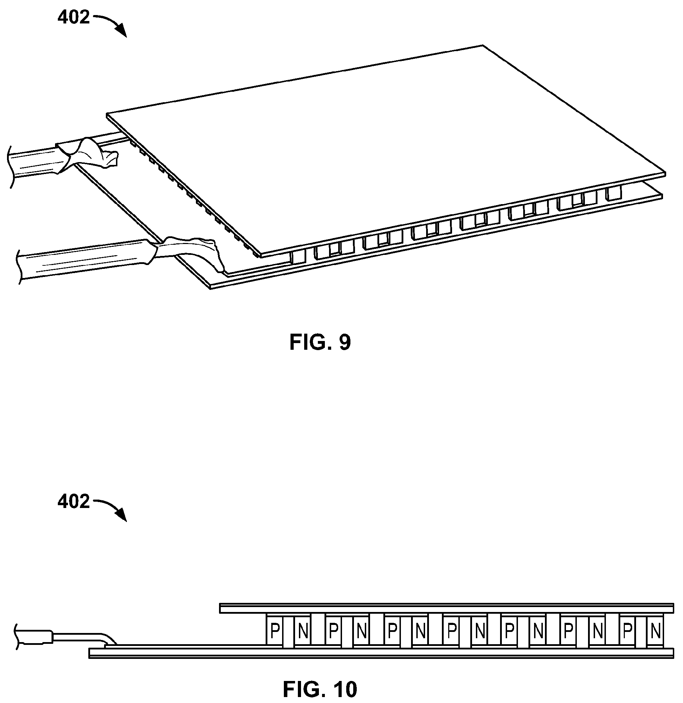

Figure 9 shows a perspective view of a thermoelectric module **402** suitable for use in a TEA disclosed herein. A typical thermoelectric module, such as the one depicted in Figure 9, includes an upper substrate and a lower substrate oriented generally parallel to one another, as well as a positive and negative lead wire attached thereto. Figure 10 shows a side view detail of the thermoelectric module **402** of Figure 9. As can be seen in Figure 10, a TEM includes alternating N-type and P-type thermoelectric elements disposed generally between the upper and lower substrates, these elements formed from suitable materials, such as bismuth telluride for example. Frequently the upper and lower substrates are rectangular in shape, though other shapes may be suitable.

As stated herein, a TEM is considered in direct thermal contact with a heat sink base where a substrate is flush against the base of a heat sink. Frequently the entire surface areas of each substrate of the TEM are covered by a heat sink base to provide optimal thermal transfer. In this manner, the TEMs are sandwiched between two heat sinks, and surrounded by thermally insulating material. It should be understood by one of skill in the art that a TEM and heat sink may be considered in direct thermal contact even in the presence of a thermal grease or paste or other thermal interface material. Such paste (not shown in the Figures) may be, just for example, aluminum oxide particles, or zinc oxide particles, in a silicone carrier.

The assembly need not be limited to only a single hot side fan sink and a pair of cold side fan sinks. Any number of configurations of thermoelectric assemblies that include a plurality of additional fan sinks on both the hot and cold sides are embraced by this disclosure. For example, a thermoelectric assembly may include dual hot side fan sinks that have air output in opposite directions as well as three cold side fan sinks with air output directions in a variety of possible configurations. Additionally, an assembly could have two dual hot side fan sinks as well as dual cold side fan sinks.

The assembly is additionally not limited to single directional output from the cold side fan sinks. A single cold side fan sink may provide two directions of air exhaust in opposite directions, depending on the housing of the fan sink, with the cold side fan sink not exhausting air towards the electrical components that may reside between dual cold side fan sinks. The housing of the cold side fan sink may be open on both ends of the heat sink to permit such dual direction exhaust.

The assembly may be modularly configurable and customizable, potentially either by the end user or the manufacturer, to permit drainage of the cold side heat sink, even where the spatial limitations of the existing structure requires horizontally mounting the assembly.

Replacing the single, large cold side heat sink with two separate cold side heat sinks in the same general footprint that includes a space therebetween did not result in a significant loss of efficiency of the cold side of the assembly or of the assembly as a whole. In contrast to conventional TEAs of the prior art, such as that seen in Figures 1A and 1B, the disclosed assembly has removed an inefficient portion of the unit and made use of the resulting space to alleviate the moisture problems known in the art. By eliminating a single, large cold side heat sink, the thermal contraction and expansion associated with TEA operation is reduced, thereby reducing incidence of moisture penetration into the TEA. The stress associated with the expansion and contraction may additionally cause the TEA to be forced out of position, causing unit failures. This change from one large heat sink to two smaller heat sinks additionally relaxes the mechanical tolerance requirements of the heat sink material, thereby reducing material costs. As discussed above, and as can be seen in the Figures, the space between the two cold side sinks may be repurposed as a locale for various electrical components, including the external electrical connections.

The hot side / cold side thermal flow could be reversed in a TEA by merely reversing the current in the TEM circuits, thereby altering the TEM heat flow. The assembly disclosed herein may include a switch that reverses the current of the TEMs without the need to rewire the assembly or the power source into the assembly. Such a reversal of current, however, may not result in equal thermal transfer efficiency in each direction, given variables such as the size, shape, and configuration of the respective heat sinks, as well as other factors.

In summary, among the many benefits of the disclosed device apparent to those of skill in the art from this description, it was discovered that the replacement of a single, large cold side heat sink with a pair of smaller cold side heat sinks provides numerous benefits: reduced moisture penetration by virtue of reduced mechanical stresses from expansion and contraction; reduced incidences of failure by shifting of an installed unit shifting by virtue of those same stresses; less cost in manufacture of heat sinks due to reduced material mechanical tolerance requirements; negligible loss of otherwise expected thermal transfer performance; directional flexibility and modularity of the cold side fan sinks; and the availability of space between the fan sinks for electrical components. Further, the moisture penetration resistance of TEAs has been enhanced through the inclusion of a series of moisture barrier measures, including a sealing layer in or near the plane that defines the hot and cold sides, an O-ring sealed screw joint, and a moisture protected wire seal. These and other benefits meet pressing needs in the art, needs unmet by existing thermoelectric assemblies.

## Claims

1. A thermoelectric assembly (200) comprising:
a cold side and a hot side, where a boundary between the hot side and the cold side is generally defined by a plane;
the assembly further comprising a fan sink on the hot side, and a pair of fan sinks (110) on the cold side;
wherein each fan sink comprises a heat sink (204) and a fan, each fan comprising a blade, and each heat sink comprising a heat sink base (108) and a fin set (106) disposed on the heat sink base, each fin set comprising a plurality of substantially parallel planar fins, the fins being aligned in an exhaust direction, the exhaust direction being parallel to the plane, wherein each fan sink is associated with an air intake direction (112) defined by an axis about which the blade is rotatably attached to the fan, the air intake direction being perpendicular to the plane; **characterized in that**
the assembly further comprises a plurality of thermoelectric modules (208; 402), the thermoelectric modules being arranged in at least one electrical circuit (404), with each thermoelectric module being in thermal contact with the fan sink on the hot side and at least one fan sink on the cold side, wherein the air intake directions of the pair of fan sinks on the cold side are substantially parallel opposing vectors; and
wherein an angle formed between the exhaust directions (114) of the pair of fan sinks on the cold side is selected from the group consisting of zero degrees, ninety degrees, and one hundred eighty degrees;
the assembly further comprising an electric bay (202) between the pair of cold side fan sinks and/or at least one moisture barrier measure.

2. The thermoelectric assembly of claim 1, wherein the thermoelectric assembly includes at least one moisture barrier measure selected from the group consisting of a wire seal (216), a series of screw O-rings, and a sealing layer (214).

3. The thermoelectric assembly of claim 1 or 2, further comprising a wire seal (216) including a head (218) having one or more holes through which a wire (226) may pass into a lead (222), each hole comprising a membrane (224).

4. The thermoelectric assembly of claim 3, wherein the head comprises a series of holes selected from the group consisting of: three holes arranged in a 1 x 3 matrix, and six holes arranged in a 2 x 3 matrix.

5. The thermoelectric assembly of any one of the preceding claims, comprising a wire seal, a series of screw O-rings, and a sealing layer.

6. The thermoelectric assembly of any one of the preceding claims, comprising eight thermoelectric modules, the thermoelectric modules being arranged in a one of a plurality of parallel circuits (404, 406) selected from the group consisting of eight circuits of one thermoelectric module each, four circuits of two thermoelectric modules each, and two circuits of four thermoelectric modules each.

7. The thermoelectric assembly of any one of the preceding claims, wherein the heat sinks comprise a material selected from the group consisting of a thermoplastic, anodized aluminum, or copper.

8. The thermoelectric assembly of any one of the preceding claims, wherein:
the fan sink on the hot side is a first fan sink, and the pair of fan sinks (110) on the cold side are a second fan sink and a third fan sink;
the plurality of thermoelectric modules (208) comprises an even numbered plurality of thermoelectric modules, the thermoelectric modules being arranged in two parallel electrical circuits (404, 406) each consisting of an equal number of thermoelectric modules, where the thermoelectric modules reside in a plane defined by the first fan sink on one side of the plane and the second and third fan sinks on the other side of the plane;
where the heat sink base (108) of the first fan sink is in thermal contact with a first side of each of the thermoelectric modules (208), and where the second fan sink is in thermal contact with a second side of half of the thermoelectric modules, and where the third fan sink is in thermal contact of the second side of the other half of the thermoelectric modules;
the air intake directions of the first fan sink is a substantially parallel opposing vector from that of the second fan sink and the third fan sink; and
the thermoelectric assembly comprising at least one moisture barrier measure selected from the group consisting of a wire seal, a series of screw O-rings, and a sealing layer.

9. The thermoelectric assembly of claim 8, further comprising a wire seal including a head having one or more holes through which a wire may pass into a lead, each hole comprising a membrane.

10. The thermoelectric assembly of claim 9, wherein the head comprises three holes arranged in a 1 x 3 matrix or six holes arranged in a 2 x 3 matrix.

11. The thermoelectric assembly of claim 8, 9, or 10, comprising eight thermoelectric modules, the thermoelectric modules being arranged in a series of parallel circuits (404, 406) selected from the group consisting of eight circuits of one thermoelectric module each, four circuits of two thermoelectric modules each, and two circuits of four thermoelectric modules each.

12. The thermoelectric assembly of claim 8, 9, 10, or 11, wherein the heat sinks comprise a material selected from the group consisting of a thermoplastic, anodized aluminum, or copper.

13. The thermoelectric assembly of any one of the preceding claims for enhancing thermal communication across a conceptual boundary plane having a hot side and a cold side:
wherein for each fan sink, the fins extend at least in a first air flow direction generally parallel to the boundary plane, and the fan is oriented with an axis of rotation along a second air flow direction generally perpendicular to the boundary plane and further oriented with respect to the heat sink such that when air flows in the second air flow direction, air also flows in the first airflow direction;
wherein the plurality of thermoelectric modules (402) are electrically coupled to a power source (400); and
wherein the first air flow direction for each fan sink is substantially parallel to the first air flow direction of another fan, and the second air flow direction for each cold side fan sink has an angle with regard to the second air flow direction of another cold side fan sink, the angle being selected from the group consisting of zero degrees, ninety degrees and one hundred eighty degrees.

14. The thermoelectric assembly of claim 13, wherein the first air flow direction is an exhaust air flow direction (114) and the second air flow direction is a fan intake air direction (112).

## Patentansprüche

1. Thermoelektrische Anordnung (200), umfassend:
eine kalte Seite und eine heiße Seite wobei eine Grenze zwischen der heißen Seite und der kalten Seite im Allgemeinen durch eine Ebene definiert ist;
wobei die Anordnung ferner einen Lüfterkühlkörper auf der heißen Seite und ein Paar Lüfterkühlkörper (110) auf der kalten Seite umfasst;
wobei jeder Lüfterkühlkörper einen Kühlkörper (204) und einen Lüfter aufweist, wobei jeder Lüfter einen Flügel umfasst und jeder Kühlkörper eine Kühlkörperbasis (108) und einen Rippensatz (106) umfasst, der auf der Kühlkörperbasis angeordnet ist, wobei jeder Rippensatz mehrere im Wesentlichen parallele planare Rippen umfasst, wobei die Rippen in einer Auslassrichtung ausgerichtet sind, wobei die Auslassrichtung parallel zu der Ebene ist, wobei jedem Lüfterkühlkörper eine Lufteinlassrichtung (112) zugeordnet ist, die durch eine Achse definiert ist, um die der Flügel drehbar an dem Lüfter befestigt ist, wobei die Lufteinlassrichtung senkrecht zu der Ebene ist; **dadurch gekennzeichnet, dass**
die Anordnung ferner mehrere thermoelektrische Module (208; 402) umfasst, wobei die thermoelektrischen Module in mindestens einem elektrischen Schaltkreis (404) angeordnet sind, wobei jedes thermoelektrische Modul mit dem Lüfterkühlkörper auf der heißen Seite und mindestens einem Lüfterkühlkörper auf der kalten Seite in thermischem Kontakt steht, wobei die Lufteinlassrichtungen des Paars von Lüfterkühlkörpern auf der kalten Seite im Wesentlichen parallele gegenüberliegende Vektoren sind; und
wobei ein Winkel, der zwischen den Auslassrichtungen (114) des Paars von Lüfterkühlkörpern auf der kalten Seite ausgebildet ist, aus der Gruppe bestehend aus null Grad, neunzig Grad und hundertachtzig Grad ausgewählt ist;
wobei die Anordnung ferner eine elektrisches Feld (202) zwischen dem Paar von Lüfterkühlkörpern auf der kalten Seite und/oder mindestens ein Feuchtigkeitsbarrieremittel umfasst.

2. Thermoelektrische Anordnung nach Anspruch 1, wobei die thermoelektrische Anordnung mindestens ein Feuchtigkeitsbarrieremittel aufweist, das ausgewählt ist aus der Gruppe bestehend aus einer Drahtversiegelung (216), einer Reihe von Schrauben-O-Ringen und einer Versiegelungsschicht (214).

3. Thermoelektrische Anordnung nach Anspruch 1 oder 2, ferner umfassend eine Drahtversiegelung (216), die einen Kopf (218) mit einem oder mehreren Löchern aufweist, durch die ein Draht (226) in eine Leitung (222) gehen kann, wobei jedes Loch eine Membran (224) umfasst.

4. Thermoelektrische Anordnung nach Anspruch 3, wobei der Kopf eine Reihe von Löchern umfasst, die ausgewählt sind aus der Gruppe bestehend aus: drei Löchern, die in einer Matrix von 1 x 3 angeordnet sind, und sechs Löchern, die in einer Matrix von 2 x 3 angeordnet sind.

5. Thermoelektrische Anordnung nach einem der vorhergehenden Ansprüche, umfassend eine Drahtplombe, eine Reihe von Schrauben-O-Ringen und eine Versiegelungsschicht.

6. Thermoelektrische Anordnung nach einem der vorhergehenden Ansprüche, umfassend acht thermoelektrische Module, wobei die thermoelektrischen Module in einem oder mehreren parallelen Schaltkreisen (404, 406) angeordnet sind, die ausgewählt sind aus der Gruppe bestehend aus acht Schaltkreisen von jeweils einem thermoelektrischen Modul, vier Schaltkreisen von jeweils zwei thermoelektrischen Modulen und zwei Schaltkreisen von jeweils vier thermoelektrischen Modulen.

7. Thermoelektrische Anordnung nach einem der vorhergehenden Ansprüche, wobei die Kühlkörper ein Material umfassen, das ausgewählt ist aus der Gruppe bestehend aus einem Thermoplast, eloxiertem Aluminium oder Kupfer.

8. Thermoelektrische Anordnung nach einem der vorhergehenden Ansprüche, wobei:
der Lüfterkühlkörper auf der heißen Seite ein erster Lüfterkühlkörper ist und das Paar von Lüfterkühlkörpern (110) auf der kalten Seite ein zweiter Lüfterkühlkörper und ein dritter Lüfterkühlkörper sind;
die mehreren thermoelektrischen Module (208) mehrere geradzahlige thermoelektrische Module umfassen, wobei die thermoelektrischen Module in zwei parallelen elektrischen Schaltkreisen (404, 406) angeordnet sind, die jeweils aus einer gleichen Anzahl von thermoelektrischen Modulen bestehen, wobei die thermoelektrischen Module in einer Ebene angeordnet sind, die durch den ersten Lüfterkühlkörper auf einer Seite der Ebene und den zweiten und den dritten Lüfterkühlkörper auf der anderen Seite der Ebene definiert ist;
wobei die Kühlkörperbasis (108) des ersten Lüfterkühlkörpers mit einer ersten Seite jeder der thermoelektrischen Module (208) in thermischem Kontakt steht und wobei der zweite Lüfterkühlkörper mit einer zweiten Seite einer Hälfte der thermoelektrischen Module in thermischem Kontakt steht und wobei der dritte Lüfterkühlkörper mit der zweiten Seite der anderen Hälfte der thermoelektrischen Module in thermischem Kontakt steht;
wobei die Lufteinlassrichtung des ersten Lüfterkühlkörpers ein im Wesentlichen paralleler gegenüberliegender Vektor von derjenigen des zweiten Lüfterkühlkörpers und des dritten Lüfterkühlkörpers ist; und
wobei die thermoelektrische Anordnung mindestens ein Feuchtigkeitsbarrieremittel umfasst, das ausgewählt ist aus der Gruppe bestehend aus einer Drahtplombe, einer Reihe von Schrauben-O-Ringen und einer Versiegelungsschicht.

9. Thermoelektrische Anordnung nach Anspruch 8, ferner umfassend eine Drahtversiegelung, die einen Kopf mit einem oder mehreren Löchern aufweist, durch die ein Draht in eine Leitung gehen kann, wobei jedes Loch eine Membran umfasst.

10. Thermoelektrische Anordnung nach Anspruch 9, wobei der Kopf drei Löcher, die in einer Matrix von 1 x 3 angeordnet sind, oder sechs Löcher umfasst, die in einer Matrix von 2 x 3 angeordnet sind.

11. Thermoelektrische Anordnung nach Anspruch 8, 9 oder 10, umfassend acht thermoelektrische Module, wobei die thermoelektrischen Module in einer Reihe von parallelen Schaltkreisen (404, 406) angeordnet sind, die ausgewählt sind aus der Gruppe bestehend aus acht Schaltkreisen von jeweils einem thermoelektrischen Modul, vier Schaltkreisen von jeweils zwei thermoelektrischen Modulen und zwei Schaltkreisen von jeweils vier thermoelektrischen Modulen.

12. Thermoelektrische Anordnung nach Anspruch 8, 9, 10 oder 11, wobei die Kühlkörper ein Material umfassen, das ausgewählt ist aus der Gruppe bestehend aus einem Thermoplast, eloxiertem Aluminium oder Kupfer.

13. Thermoelektrische Anordnung nach einem der vorhergehenden Ansprüche zur Verbesserung der thermischen Verbindung über eine konzeptionelle Grenzebene mit einer heißen Seite und einer kalten Seite:
wobei sich für jeden Lüfterkühlkörper die Rippen mindestens in einer ersten Luftströmungsrichtung erstrecken, die im Allgemeinen parallel zu der Grenzebene ist, und der Lüfter mit einer Drehachse entlang einer zweiten Luftströmungsrichtung ausgerichtet ist, die im Allgemeinen senkrecht zu der Grenzebene ist, und ferner in Bezug auf den Kühlkörper derart ausgerichtet ist, dass beim Strömen von Luft in der zweiten Luftströmungsrichtung Luft auch in der ersten Luftströmungsrichtung strömt;
wobei die mehreren thermoelektrischen Module (402) mit einer Stromquelle (400) elektrisch gekoppelt sind; und
wobei die erste Luftströmungsrichtung für jeden Lüfterkühlkörper im Wesentlichen parallel zu der ersten Luftströmungsrichtung des anderen Lüfters ist und die zweite Luftströmungsrichtung für jeden Lüfterkühlkörper auf der kalten Seite einen Winkel in Bezug auf die zweite Luftströmungsrichtung eins anderen Lüfterkühlkörper auf der kalten Seite hat, wobei der Winkel ausgewählt ist aus der Gruppe bestehend aus null Grad, neunzig Grad und hundertachtzig Grad.

14. Thermoelektrische Anordnung nach Anspruch 13, wobei die erste Luftströmungsrichtung eine Auslass-Luftströmungsrichtung (114) ist und die zweite Luftströmungsrichtung eine Lüftereinlass-Luftströmungsrichtung ist (112) ist.

## Revendications

1. Assemblage thermoélectrique (200) comprenant :
un côté froid et un côté chaud, une limite entre le côté chaud et le côté froid étant définie de manière générale par un plan ;
l'assemblage comprenant en outre un puits de ventilation sur le côté chaud et une paire de puits de ventilation (110) sur le côté froid ;
dans lequel chaque puits de ventilation comprend un puits thermique (204) et un ventilateur, chaque ventilateur comprenant une pale et chaque puits thermique comprenant une base de puits thermique (108) et un ensemble d'ailettes (106) disposé sur la base du puits thermique, chaque ensemble d'ailettes comprenant une pluralité d'ailettes planaires sensiblement parallèles, les ailettes étant alignées dans un sens d'échappement, le sens d'échappement étant parallèle au plan, chaque puits de ventilation étant associé à un sens d'admission d'air (112) défini par un axe autour duquel la pale est fixée de manière à pouvoir tourner au ventilateur, le sens d'admission d'air étant perpendiculaire au plan ; **caractérisé en ce que**
l'assemblage comprend en outre une pluralité de modules thermoélectriques (208; 402), les modules thermoélectriques étant disposés dans au moins un circuit électrique (404), chaque module thermoélectrique étend en contact thermique avec le puits de ventilation sur le côté chaud et au moins un puits de ventilation sur le côté froid, les sens d'admission d'air de la paire de puits de ventilation sur le côté froid étant des vecteurs opposés sensiblement parallèles ; et
dans lequel un angle formé entre les sens d'échappement (114) de la paire de puits de ventilation sur le côté froid est sélectionné nous dans le groupe composé de zéro degré, quatre-vingt-dix degrés et cent quatre-vingt degrés ;
l'assemblage comprenant en outre une baie électrique (202) entre la paire de puits de ventilation du côté froid et/ou au moins une mesure de barrière d'humidité.

2. Assemblage thermoélectrique selon la revendication 1, dans lequel l'assemblage thermoélectrique comprend au moins une mesure de barrière d'humidité sélectionnée dans le groupe composé d'un câble de fermeture (216), d'une série de joint torique à vis et d'une couche de scellement (214).

3. Assemblage thermoélectrique selon la revendication 1 ou 2, comprenant en outre un câble de fermeture (216) possédant une tête (218) dotée d'un ou plusieurs trous à travers lesquels un câble (226) peut passer dans un conducteur (222), chaque trou comprenant une membrane (224).

4. Assemblage thermoélectrique selon la revendication 3, dans lequel la tête comprend une série de trous sélectionnés dans le groupe composé de trois trous disposés dans une matrice de 1 x 3 et six trous disposés dans une matrice de 2 x 3.

5. Assemblage thermoélectrique selon l'une quelconque des revendications précédentes, comprenant un câble de fermeture, une série de joints toriques à vis et une couche de scellement.

6. Assemblage thermoélectrique selon l'une quelconque des revendications précédentes, comprenant huit modules thermoélectriques, les modules thermoélectriques étant disposés dans l'un de la pluralité de circuits parallèles (404, 406) sélectionnés dans le groupe composé de huit circuits d'un module thermoélectrique chacun, quatre circuits de deux modules thermométriques chacun et deux circuits de quatre modules thermoélectriques chacun.

7. Assemblage thermoélectrique selon l'une quelconque des revendications précédentes, dans lequel les puits thermiques contiennent un matériau sélectionné dans le groupe composé d'un thermoplastique, de l'aluminium anodisé ou du cuivre.

8. Assemblage thermoélectrique selon l'une quelconque des revendications précédentes, dans lequel :
le puits de ventilation du côté chaud est un premier puits de ventilation et la paire de puits de ventilation (110) du côté froid est un deuxième puits de ventilation et un troisième puits de ventilation ;
la pluralité de modules thermoélectriques (208) comprend une pluralité en nombre pair de modules thermoélectriques, les modules thermoélectriques étant disposés dans deux circuits électriques parallèles (404, 406) consistant chacun en un nombre égal de modules thermoélectriques, les modules thermoélectriques se trouvant dans un plan défini par le premier puits de ventilation d'un côté du plan et les deuxième et troisième puits de ventilation sur l'autre côté du plan ;
dans lequel la base de puits thermique (108) du premier puits de ventilation est en contact thermique avec un premier côté de chacun des modules thermoélectriques (208), et dans lequel le deuxième puits de ventilation est en contact thermique avec un deuxième côté de la moitié des modules thermoélectriques et dans lequel le troisième puits de ventilation est en contact thermique avec le deuxième côté de l'autre moitié des modules thermoélectriques ;
le sens d'admission d'air du premier puits de ventilation est un vecteur opposé sensiblement parallèle de celui du deuxième puits de ventilation et du troisième puits de ventilation ; et
l'assemblage thermoélectrique comprenant au moins une mesure de barrière d'humidité sélectionnée dans le groupe composé d'un câble de fermeture, d'une série de joints toriques à vis et d'une couche de scellement.

9. Assemblage thermoélectrique selon la revendication 8, comprenant en outre un câble de fermeture comportant une tête dotée d'un ou plusieurs trous à travers lesquels un câble peut passer dans un conducteur, chaque trou comportant une membrane.

10. Assemblage thermoélectrique selon la revendication 9, dans lequel la tête comprend trois trous disposés dans une matrice de 1 x 3 ou 6 trous disposés dans une matrice de 2 x 3.

11. Assemblage thermoélectrique selon la revendication 8, 9, ou 10, comprenant huit modules thermoélectriques, les modules thermoélectriques étant disposés dans une série de circuits parallèles (404, 406) sélectionnés dans le groupe composé de huit circuits d'un module thermoélectrique chacun, quatre circuits de deux modules thermoélectriques chacun et deux circuits de quatre modules thermoélectriques chacun.

12. Assemblage thermoélectrique selon la revendication 8, 9, 10, ou 11, dans lequel les puits thermiques comprennent un matériau sélectionné dans le groupe composé d'un thermoplastique, d'aluminium anodisé ou de cuivre.

13. Assemblage thermoélectrique selon l'une quelconque des revendications précédentes pour améliorer la communication thermique sur un plan limite conceptuel comportant un côté chaud et un côté froid :
dans lequel, pour chaque puits de ventilation, les ailettes s'étendent nous nous au moins dans un premier sens d'écoulement d'air parallèle d'une manière générale au plan limite et le ventilateur est orienté avec un axe de rotation le long d'un second sens d'écoulement d'air de manière générale perpendiculaire au plan limite et orienté en outre par rapport au puits thermique de manière à ce que, lorsque de l'air afflue dans le second sens d'écoulement d'air, de l'air afflue aussi dans le premier sens d'écoulement d'air nous ;
dans lequel la pluralité de modules thermoélectriques (402) sont couplés au niveau électrique à une source de courant (400) ; et
dans lequel le premier sens d'écoulement d'air pour chaque puits de ventilation est sensiblement parallèle au premier sens d'écoulement d'air d'un autre ventilateur et le second sens d'écoulement d'air pour chaque puits de ventilation du côté froid décrit un angle par rapport au second sens d'écoulement d'air d'un autre puits de ventilation du côté froid, cet angle étant sélectionné dans le groupe composé de zéro degré, quatre-vingt-dix degrés et cent quatre-vingt degrés.

14. Assemblage thermoélectrique selon la revendication 13, dans lequel le premier sens d'écoulement d'air est un sens d'écoulement d'air d'échappement (114) et le second sens d'écoulement d'air est un sens d'air d'admission de ventilateur (112).
